# EUROPEAN PATENT APPLICATION

(11) **EP 4 560 920 A1**
(43) Date of publication of application: **28.05.2025**
(21) Application number: 23211482.7
(22) Date of filing: 22.11.2023
(51) Int. Cl.: H03K 17/082, H02H 3/08, H02H 3/087, H02H 9/02, H02J 7/00

(54) **SOLID STATE SWITCH, DC POWER SOURCE AND A DC POWER NETWORK OF AN AIRCRAFT EQUIPPED THEREWITH AS WELL AS OPERATION METHODS**

(71) Applicant: Airbus S.A.S., 31700 Blagnac (FR)
(72) Inventor: STEINER, Gerhard, Taufkirchen 82024 (DE); KAPAUN, Florian, Taufkirchen 82024 (DE)
(74) Representative: OTN Airbus SAS

(57) **Abstract**

In order to improve flexibility and to save weight and to reduce complexity providing electrical consumers of an aircraft with energy, the invention provides a solid state switch (28) for a DC power source (20) or a DC power network (32) of an aircraft (10), wherein the solid state switch (28) comprises a first (S1, 42-1) and a second (S2, 42-2) power field-effect transistor electrically connected anti-serial with each other, a current detection means (38) for measuring a current flowing through the anti-serial connected field-effect transistors (S1, S2; 42-1, 42-2), and a controller (34) configured to control the first and second field-effect transistors (S1, S2, 42-1, 42-2) independently from each other, wherein the controller (34) is configured for selectively conducting a first or second diode operation with a first or second current flow direction (FD, DD; RD, CD) by activating the one of the first and second field-effect transistors (S1, 42-1) and inactivating the other of the first and second field-effect transistors (S2, 42-2) when the current is below a current measuring threshold and activating the second field-effect transistor (S2, 42-2) when the current is above the current measuring threshold and for conducting a fuse operation by inactivating at least one or both of the first and second field-effect transistors (S1, S2; 42-1, 42-2) for limiting or stopping current flow when a current in the first current direction above a first current limit threshold is measured or when a current in the second current direction above a second current limit threshold is measured.

## Description

The invention relates to a solid state switch for a DC power source or a DC power network of an aircraft, wherein the solid state switch comprises a first and a second power field-effect transistor electrically connected anti-serial with each other. Further, the invention relates to a DC power source for an aircraft, a DC power network for an aircraft as well as an aircraft provided with one or several of such solid state switches. Still further, the invention relates to operation methods of such solid state switches.

The invention relates to the field of aircraft using electrical power.

An object of the invention is to provide an enhanced solid state switch for a DC power source or a DC power network of an aircraft.

For achieving such object, the invention provides a solid state switch according to claim 1. A DC power source for an aircraft, a DC power network for an aircraft as well as an aircraft equipped with at least one or several of such solid state switches and operation methods therefore are subject-matters of the further independent claims.

Advantageous embodiments are subject-matters of the dependent claims.

The invention provides according to a first aspect thereof a solid state switch for a DC power source or a DC power network of an aircraft, wherein the solid state switch comprises a first and a second power field-effect transistor electrically connected anti-serial with each other, a current detection means for measuring a current flowing through the anti-serial connected field-effect transistors, and a controller configured to control the first and second field-effect transistors independently from each other, wherein the controller is further configured for:
a) conducting a first diode operation with a first current direction by activating the first field-effect transistor and inactivating the second field-effect transistor when the current is below a first threshold and activating the second field-effect transistor when the current is above the first threshold;
b) conducting a second diode operation with a second current direction by activating the second field-effect transistor and inactivating the first field-effect transistor when the current is below a second threshold and activating the first field-effect transistor when the current is above the second threshold; and
c) conducting a fuse operation by inactivating at least one or both of the first and second field-effect transistors for limiting or stopping current flow when a current in the first current direction above a third threshold is measured or when a current in the second current direction above a fourth threshold is measured.

Preferably, the first or second threshold is the minimum current that is measurable with the current detection means.

Preferably, the controller is configured to inactivate, in the first diode operation, the second field-effect transistor again when the current is lower than the first threshold.

Preferably, the controller is configured to inactivate, in the second diode operation, the first field-effect transistor again when the current is lower than the second threshold.

Preferably, the controller is configured to conduct a fuse operation with different protection levels and/or different timings depending on the current flow direction.

Preferably, the controller is configured to conduct a bipolar diode operation wherein the current direction is changed with adapted control commands.

Preferably, the controller is configured to control the first and/or second field-effect transistor depending on a drain-source voltage level in order to control and/or limit the voltage across the anti-serial connected first and second field-effect transistors.

According to another aspect, the invention provides a DC power source for an aircraft, comprising an energy source and a solid state switch according to any of the aforementioned embodiments configured and arranged to connect the energy source to a load.

In some embodiments, the energy source is or comprises a fuel cell and wherein the controller is configured to conduct the first diode operation and the fuse operation wherein the first field-effect transistor is operated as a fuse and the second field-effect transistor is operated as an active diode.

In some embodiments, the energy source is or comprises a rechargeable battery and wherein the controller is configured to conduct the fuse operation wherein the first field-effect transistor is operated as a fuse with the discharge current limit and the second field-effect transistor is operated as a fuse with the charge current limit.

According to another aspect, the invention provides a DC power network for an aircraft comprising a plurality of DC power sources and several solid state switches according to any of the aforementioned embodiments.

In some embodiments, DC power network comprises at least one DC power source according to any of the aforementioned embodiments.

In some embodiments, DC power network comprises at least one bidirectional current path including a solid state switch according to any of the aforementioned embodiments connecting the outputs of at least two of the DC power sources.

According to another aspect, the invention provides an aircraft comprising a solid-state switch, a DC power source, or a DC power network according to any of the aforementioned embodiments.

According to another aspect, the invention provides an operation method for operating a solid state switch in a DC power source or in DC power network of an aircraft, wherein the solid state switch comprises a first and a second power field-effect transistor electrically connected anti-serial with each other, the method comprising:
measuring a current flowing through the anti-serial connected field-effect transistors, and selectively conducting a first diode operation with a first current direction, a second diode operation with a second current direction, and a fuse operation by
a) for conducting the first diode operation, activating the first field-effect transistor and inactivating the second field-effect transistor when the current is below a first threshold and activating the second field-effect transistor when the current is above the first threshold;
b) for conducting the second diode operation, activating the second field-effect transistor and inactivating the first field-effect transistor when the current is below a second threshold and activating the first field-effect transistor when the current is above the second threshold;
c) for conducting the fuse operation, inactivating at least one or both of the first and second field-effect transistors for limiting or stopping current flow when a current in the first current direction above a third threshold is measured or when a current in the second current direction above a fourth threshold is measured.

In some embodiments, operation method comprises, in step a) or step b), activating both field-effect transistors when a current measuring circuit measures a current above its measuring threshold. In other words, the first threshold is preferably the limit of detection (LOD or LoD) of the current measuring means for the corresponding current flow direction. The limit of detection is the lowest signal, or the lowest corresponding quantity to be determined (or extracted) from the signal, that can be observed with a sufficient degree of confidence or statistical significance. In some embodiments, this threshold is set as 1 to 10 % over a noise level or is set to 0 + Δx, wherein 0 is the zero point, Δx is the measurement deviation or measurement tolerance for the current measuring means.

Especially, a body diode of the second field-effect transistor is directed in the first current flow direction which may be a forward current flow direction for providing a load with current from an energy source or a discharge current flow direction for discharging a battery. A body diode of the first field-effect transistor is directed in the second current flow direction, opposite to the first current flow direction. The second current flow direction may be a reverse current flow direction or a charging current flow direction.

In some embodiments, operation method comprises inactivating, in the first diode operation, the second field-effect transistor again when the current becomes lower than the first threshold.

In some embodiments, operation method comprises inactivating, in the second diode operation, the first field-effect transistor again when the current becomes lower than the second threshold.

In some embodiments, operation method comprises conducting the fuse operation with different protection levels and/or different timings depending on the current flow direction.

In some embodiments, operation method comprises conducting a bipolar diode operation wherein the current direction is changed with adapted control commands.

In some embodiments, operation method comprises controlling the first and/or second field-effect transistor depending on a drain-source voltage level in order to control and/or limit the voltage across the anti-serial connected first and second field-effect transistors.

According to another aspect, the invention provides a method for operating a DC power source for an aircraft, the DC power source comprising an energy source and a solid state switch connecting the energy source to a load and including a first and a second power field-effect transistor electrically connected anti-serial with each other, wherein the solid states switch is operated with an operation method according to any of the aforementioned embodiments.

In some embodiments, where the energy source is or comprises a fuel cell, the solid state switch is operated such that the first field-effect transistor is operated as a fuse and the second field-effect transistor is operated as an active diode.

In some embodiments, where the energy source is or comprises a rechargeable battery, the first field-effect transistor is operated as a fuse with a discharge current limit and the second field-effect transistor is operated as a fuse with a charge current limit.

In the following some notable aspects and advantages of some preferred embodiments of the invention are explained.

Some embodiments provide flexible protection and advanced functionalities to fulfil the needs of targeted aircraft applications such as flexible control to cover multiple applications, e.g., in case of network reconfiguration.

Today's switching and protection devices are mainly optimized for cost, not for efficiency and weight. Preferred embodiments of the invention provide switching and protection devices for DC power sources and/or DC power network for aircraft which are enhanced with regard to efficiency and weight.

The main tasks for state-of-the-art solid state switches are
- replacing contactors or
- replacing fuses.

Today's switching and protection devices are optimized for one of both aforementioned tasks. For contactor replacing low losses are priority but not very high speed or high interrupting currents. For fuse replacement sufficient interrupting current and speed is required. Limitation of overvoltage due to switching is normally conducted by means of a dedicated overvoltage protection block which is usually not matched to the maximum performance of the switch but to a dedicated application need.

Preferred embodiments of the invention provide a solid state switch that is usable for replacing a contactor and for replacing a fuse. Some embodiments provide a switch with low losses in a connecting or contacting mode and enables high speed and high interrupting currents.

Preferred embodiments of the invention provide a diode-like behaviour that can be combined with other tasks.

Preferred embodiments of the invention provide a switching and protecting device for switching and protecting a DC power source of an aircraft or for switching and protecting parts of a DC power network of an aircraft wherein the switching and protecting device shows high flexibility to cover more complex applications.

Preferred embodiments of the invention optimize the control of solid state switches if they are operated as an "active" diode, for protection and also for reconfiguration applications.

Preferred embodiments use anti-serial connected field-effect transistors (FETs). FET based solid state switches also allow current flow from source to drain if they are in ON state. They also come with a body diode. In preferred embodiments, FETs are configured to be used as an "active diode" and as well for flexible control of applications with bidirectional current flow.

In preferred embodiments, a bidirectional functionality is achieved by anti-serial connection of two unidirectional devices. Bidirectional setup is also applicable for coupling / reconfiguration tasks of DC networks.

Therefore, preferred embodiments of the invention show high performance in terms of efficiency and flexibility for various applications required for aircraft networks.

The number of different components necessary for each application is reduced.

Due to the low resistance of the solid state switch design the overall system efficiency is optimized.

Preferred embodiments of the invention enable a flexible control of DC networks while minimizing functional bricks. This reduction is possible because fast reaction, diode behaviour and flexible current limiting is realized by control. Also, different current protection levels depending on the flow direction are adjustable by control.

This combination of functionality ensures that the brick is suitable for reconfigurable networks. Aircrafts networks usually require emergency operation possibility and therefore reconfiguration features.

Embodiments of the invention are explained below referring to the accompanying drawings in which:
- Fig. 1: is a plan view of an aircraft with a DC power source that may be part of a DC power network and with several solid state switches as switching and protection device for the DC power source and for parts of the DC power network, respectively;
- Fig. 2-4: are block diagrams of different embodiments of the solid state switches for use in the aircraft of Fig. 1;
- Fig. 5: is a schematic block diagram wherein a conventional DC power source with a fuel cell as power source for use in an aircraft is shown on the left and a DC power source with the solid state switch according an embodiment of the invention is shown on the right;
- Fig. 6: is a schematic block diagram wherein a conventional DC power source with a rechargeable battery as power source for use in an aircraft is shown on the left and a DC power source with the battery and the solid state switch according an embodiment of the invention is shown on the right;
- Fig. 7: is a schematic block diagram of the DC power network of the aircraft of Fig. 1 according to an embodiment of the invention; and
- Fig. 8: is a block diagram for comparison of a conventional DC power network for the aircraft shown on the left with the DC power network according to claim to the embodiment of the invention on the right.

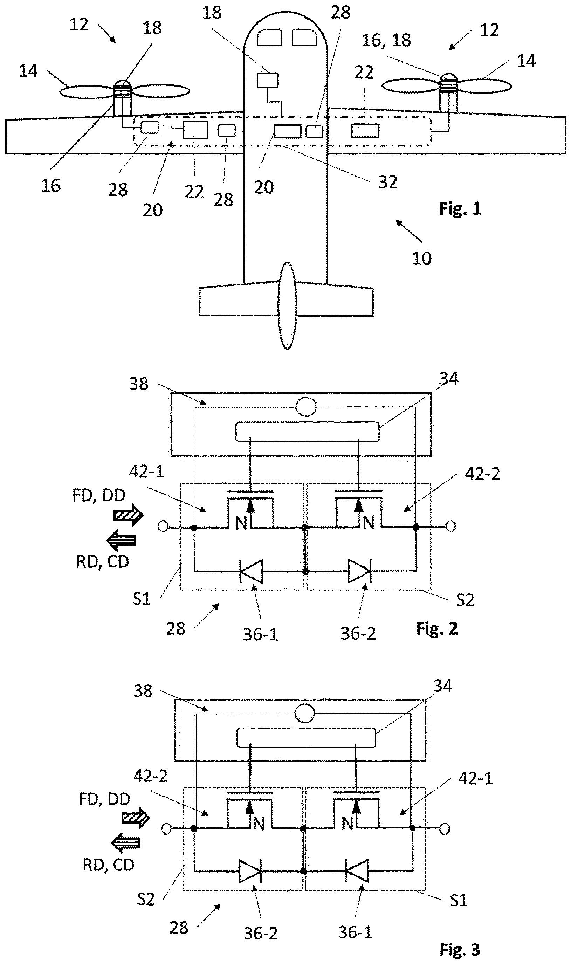

Fig. 1 shows an aircraft 10 including a propulsion system 12. The propulsion system 12 comprises propulsion elements 14 such as propellers and electrical motors 16 for driving the propulsion elements 14, respectively. Further, the aircraft 10 includes DC power sources 20 for powering the motor 16 and other loads 18 such as electrical actuators, pumps or electronic equipment.

The DC power sources 20 comprise an energy source 22 such as a rechargeable battery 24 or a fuel cell 26 and a solid state switch 28 as switching and protecting device 30. Several DC power sources 20 are connected in a DC power network 32 which also includes solid state switches 28 as switching and protection devices 30 enabling a reconfiguration of the DC power network 32, for example for the event that one of the energy sources 22 cannot provide enough power or that one of the loads 16, 18 needs more power.

Fig. 2 to 4 show different embodiments for the solid state switch 28. For a bidirectional topology, the solid state switch 28 includes a first and a second unidirectional logical switch S1, S2 which are connected anti-serial. The first and second logical switches S1, S2 are independently controllable by means of a controller 34.

The first and second logical switches S1, S2 are semiconductor devices with body diodes 36-1, 36-2. Further, the solid state switch 28 comprises a current detection means 38 for measuring a power current flowing through the power path of the solid state switch 28. The current detection means 38 may be a detection circuit 40 for the current measurement wherein parts thereof may also be implemented in the controller 34.

The controller 34 is computer-implemented. In some embodiments, the controller 34 includes a processor and a memory (not shown) with control software. The controller 34 may be integrated on a component carrying the semiconductors elements of the solid state switch 28 or may be part of a separate control device such as a central control of the DC power source 20, a central control of the DC power network 32 or a central control of the aircraft 10.

As shown in Figs. 2 to 4, the first logical switch S1 with the first body diodes 36-1, 36-2 is a first field-effect transistor 42-1, shortly referred to as first FET 42-1, and the second logical switch S2 is a second field-effect transistor 42-2, shortly referred to as second FET 42-2.

As this is well known, the field-effect transistor (FET) is a type of transistor that uses an electric field to control the flow of current in a semiconductor. FETs have three terminals: Source, Gate, and Drain. FETs control the flow of current by the application of a voltage to the Gate, which in turn alters the conductivity between the Drain and Source.

The controller 34 is configured to optimize the control of the solid state switch 28 if it is operated as an "active" diode, for protection and also for reconfiguration applications.

FET based solid state switches 28 also allow current flow from Source to Drain if they are in ON state. They also come with a body diode 36-1, 36-2. Therefore the FET's 42-1, 42-2 are suited to be used as an "active diode" and as well for flexible control of applications with bidirectional current flow.

A bidirectional functionality is achieved by anti-serial connection of two unidirectional devices. Bidirectional setup is also applicable for coupling / reconfiguration tasks of DC power networks 32.

As shown in Figs. 2 to 4, different types of FETs 42-1, 42-2 such as n-type N or p-type P can be applied. Anti-serial means that the either the sources S of the FETs 42-1, 42-2 are electrically connected with each other so that the FETs 42-1, 42-2 have a common source node or the drains D of the FETs 42-1, 42-2 are connected so that the FETs 42-1, 42-2 have a common drain node.

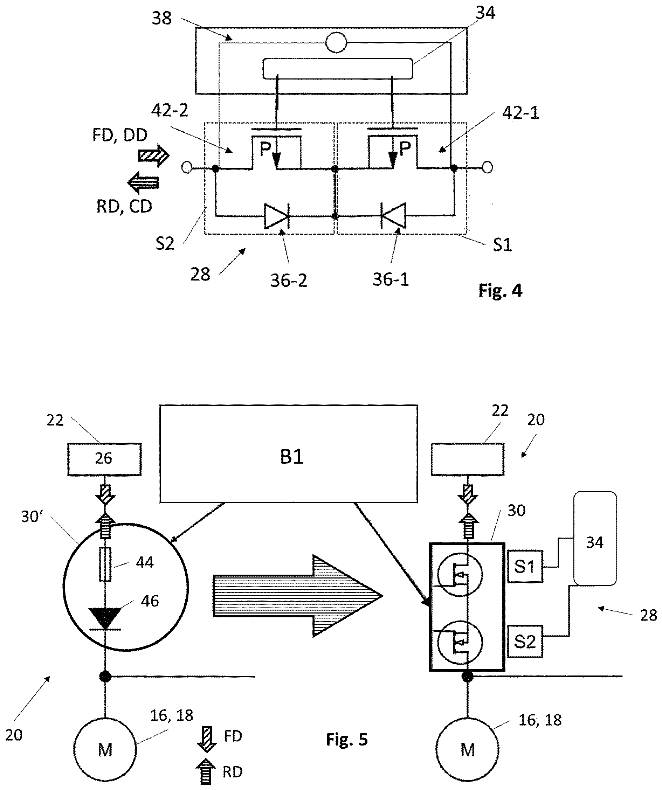

The controller 34 is configured for selectively controlling of specific operations which are now explained on basis of the embodiment of Fig. 2 and with reference to Figs. 5 to 8. The solid state switch 28 is used to replace conventional switching and protection devices 30' which use fuses 44, diodes 46 and/or contactors 48.

The use of the solid state switches 28 enables a flexible control of DC networks while minimizing functional bricks. This reduction is possible because fast reaction, diode behaviour and flexible current limiting is realized by control. Also, different current protection levels depending on the flow direction are adjustable by control.

This combination of functionality ensures that the brick is suitable for reconfigurable networks. Aircrafts networks usually require emergency operation possibility and therefore reconfiguration features. Especially, the control 34 is configured to control the logical switches S1, S2 independently for bidirectional application and reconfiguration applications.

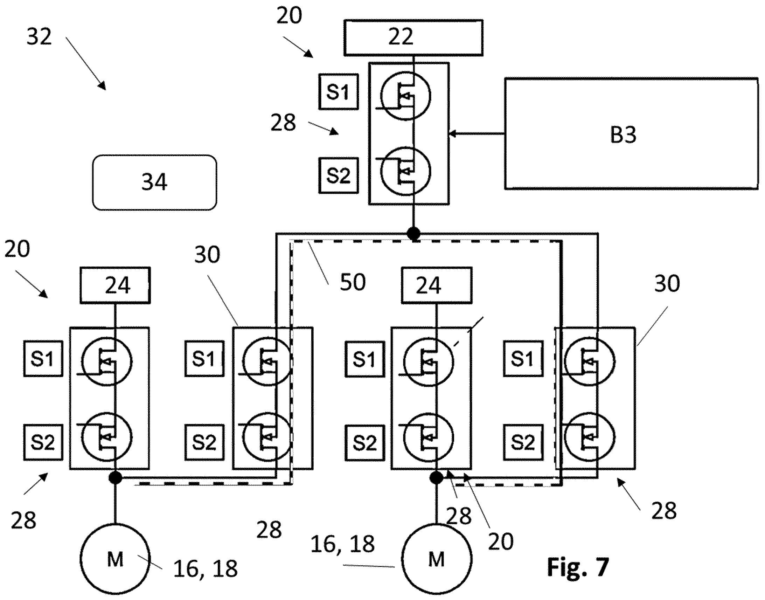

In Figs. 5 to 8, the main components and the operation principles are shown. To avoid overloaded schematics, the following components are not shown:
- Detection circuit for the current measurements
- Body diodes of the semiconductors
- communication lines between control and switches S1, S2 in Fig. 7

The controller 34 is configured to conduct a diode operation by control as follows.

The solid state switch 28 can be selectively operated in a first diode operation with a first current flow direction, e.g., a forward current flow direction FD, or in a second diode operation with a second current flow direction, e.g., a reverse current flow direction.

Small current operation activates, in the first diode operation, only the first logical switch S1 i.e., the first logical switch S1 is switched in the ON-state. The first logical switch S1 is intended to limit the peak current and replaces the fuse 44 of a conventional switching and protection device 34. At S2 the body diode 36-2 of S2 is in forward direction FD, see Figs. 2 and 5. Therefore, the solid state switch 28 behaves like a diode and shows diode performances with regard to speed and reverse leakage current values.

For operation at higher currents the current flow detection is ensured and therefore also the second logical switch S2 is activated (in the ON-state) and bypasses the body diode 36-2 of the logical switch S2. This leads to lower losses compared to diode based principles.

The control 34 deactivates the second logical switch S2 again (OFF-state) if the current is lower than the reliable measurable current. Then, only the body diode 36-2 of the second logical switch S2 is active, which results in diode behaviour.

For conducting the second diode operation with the second current flow direction, the control of the logical switches S1 and S2 is exchanged compared to the first diode operation. Thus, the solid state switch 28 behaves like an active diode in the second flow direction BD.

Thus, the controller 34 is configured for conducting a bipolar diode operation. Also, the current direction can be changed with adapted control commands. This ensures a flexible diode behaviour in both current flow directions FD, BD.

In some embodiments, the control 34 is configured for an overvoltage limitation. Activating or driving in linear operation is possible by control depending on the Drain-Source voltage level. So, the voltage across the bidirectional solid state switch is controlled and limited.

Further, the control 34 is configured for controlling a fuse operation. Especially, the fuse operation is conducted by inactivating (set in OFF-state) at least one or both of the first and second field-effect transistors for limiting or stopping current flow when a current in the first current direction above a specific threshold for the first current direction is measured or when a current in the second current direction above a specific threshold for the second current flow direction is measured.

Thus, different protection levels and timings, depending on the current flow direction, are feasible by control.

Different examples of applications are now explained with reference to Figs. 5 to 8.

Fig. 5 shows a schematic explaining a fuel cell protection with a conventional switching and protection device 30' having a fuse 44 and a diode 46 on the left and a switching and protection device 30 embodied by a solid state switch 28 in accordance with an embodiment of the invention on the right.

Fuel cell systems have to be protected to short circuits and to reverse currents.

To ensure this, the controller 34 controls such that the first logical switch S1 is operated as a fuse as explained above for the fuse operation and the second logical switch S2 is operated as an active diode as explained above for the first diode operation. So, both requirements are covered by one bidirectional solid state switch 28.

As indicated in the block B1, the bidirectional solid state switch 28 with the corresponding control 34 replaces the fuse 44 and the diode 46 while keeping their functionality.

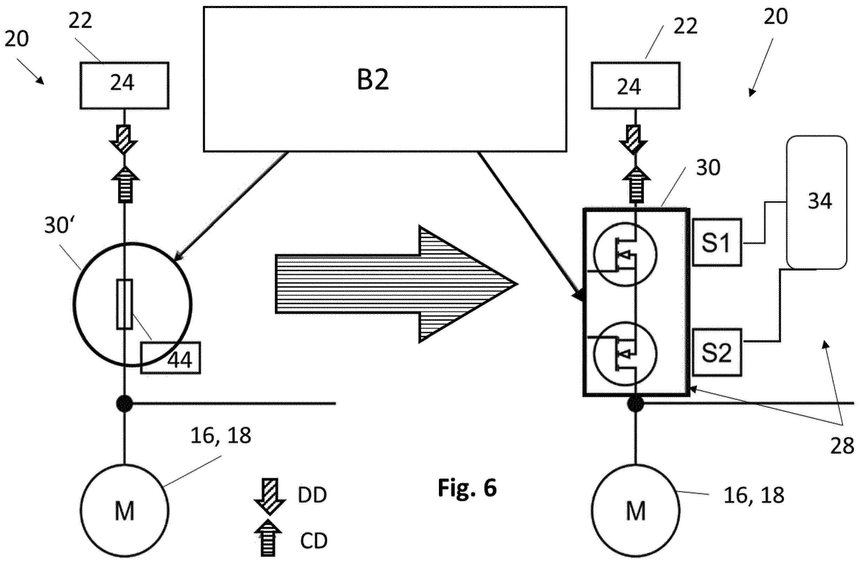

Fig. 6 shows a schematic explaining a battery protection with a conventional switching and protection device 30' having just a fuse 44 on the left side of the figure and a switching and protection device 30 embodied by a solid state switch 28 in accordance with an embodiment of the invention on the right side of the figure. The discharging current flow direction DD and the charging current direction CD are marked in Fig. 6 with corresponding arrows.

In case of battery protection, different maximum protection levels for charging / discharging currents DD, CD are necessary to ensure proper protection. To ensure this, the controller 34 operates the first logical switch S1 as a fuse with the discharge current limit and operates the second logical switch S2 as a fuse with the charge current limit. So, both requirements are covered by one bidirectional solid state switch 28. This adds more safety on battery operation and protection.

As indicated in block B2, the bidirectional solid state switch 28 with the corresponding control 34 replaces the fuse and adds enhanced functionality, e.g., different current protection levels based on the current flow direction CD, DD.

A network coupling application for the solid state switch 28 is explained now with reference to Fig. 7.

Fig. 7 is a block diagram of a possible embodiment for the DC power network 32 of the aircraft 10, with the several DC power sources 20. Some of the power sources 20 are equipped with a battery 24 as energy source 22. Further, some power sources 20 may have active energy sources 22 such as fuel cells 26. Additional solid state switches 28 according to embodiments of the invention are provided for coupling of different components of the DC power network 32.

If both logical switches S1, S2 are in "ON" state, the solid state switch 28 ensures low-loss current flow in both directions. Therefore, also a net-coupling application for reconfiguration of networks such as the DC power network 32 is possible. In this case, also a bus tie contactor 48 for coupling the sub-networks is replaced.

In the example of Fig. 7, a first and a second battery 24 as well as the energy source 22, such as a fuel cell 26 or similar, are coupled. The different protection requirements for the energy source 22 (e.g., fuel cell 26) and the batteries 24 are ensured by the dedicated bidirectional solid-state switches 28 to the batteries 24 and to the energy source 22.

In Fig. 7, a bidirectional current path 50 for the coupling is shown by a dashed line.

As indicated in block B3, both the first and second logical switch S1, S2 are provided for fuse replacement and to prevent a reverse current flow to the energy source 22 such as the fuel cell 26.

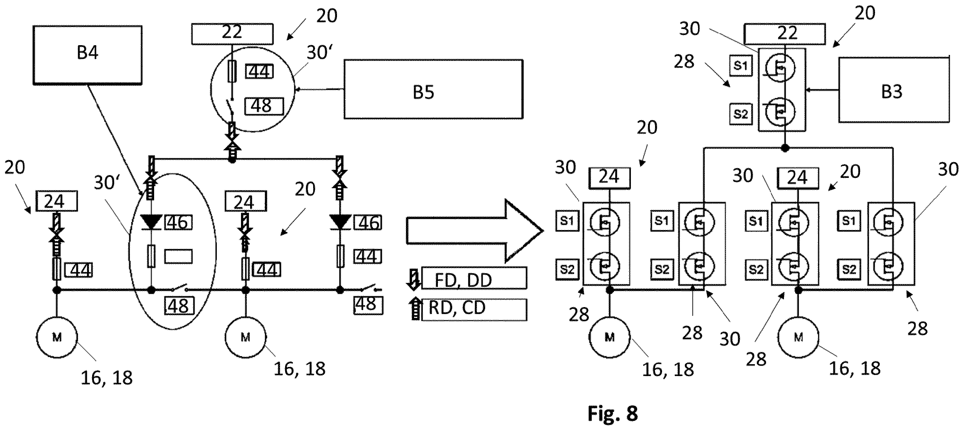

Fig. 8 compares a conventional DC power network 32' with conventional switching and protective devices 30' including fuses 44, diodes 46, and/or contactors 48 with the DC power network 32 according to the embodiment of Fig. 7, wherein current flow directions are marked with corresponding arrows FD (forward current flow direction or discharging current flow direction in case of batteries) and RD (reverse current flow direction or charging current flow direction in case of batteries).

As indicated in block B4, each solid state switch 28 in the bidirectional current path 50 replaces three components while keeping their functionality. As indicated in block B5, the solid state switch 28 connecting the energy source 22 to the bidirectional current path 50 replaces two components while keeping their functionality and provides two different protection levels for energy sources 22 such as further battery packs or generators/motors and also diode functionality for fuel cells 26 as energy source 22.

Thus, the replacement of conventional switching and protecting devices 30 in a DC power source 20 and/or a DC power network 32 of an aircraft enables saving of weight, lower losses, less complexity, an improved flexibility due to fully controllable design, a clamping of overvoltage during switching. Thus, new topologies can be achieved.

The different examples for application and the operation principles are explained by using the example of Fig. 2 as the solid state switch. The corresponding operation logic may be applied to further configurations such as shown in Figs. 3 and 4 depending on the polarity and direction of the body diodes 36-1, 36-2.

In order to improve flexibility and to save weight and to reduce complexity when providing electrical consumers (16, 18, 50) of an aircraft (10) with energy, a solid state switch (28) for a DC power source (20) or a DC power network (32) of an aircraft (10) has been proposed, wherein the solid state switch (28) comprises a first (S1, 42-1) and a second (S2, 42-2) power field-effect transistor electrically connected anti-serial with each other, a current detection means (38) for measuring a current flowing through the anti-serial connected field-effect transistors (S1, S2; 42-1, 42-2), and a controller (34) configured to control the first and second field-effect transistors (S1, S2, 42-1, 42-2) independently from each other, wherein the controller (34) is configured for selectively conducting a first or second diode operation with a first or second current flow direction (FD, DD; RD, CD) by activating one of the first and second field-effect transistors (S1, 42-1) and inactivating the other of the first and second field-effect transistors (S2, 42-2) when the current is below a current measuring threshold and activating the second field-effect transistor (S2, 42-2) when the current is above the current measuring threshold and for conducting a fuse operation by inactivating at least one or both of the first and second field-effect transistors (S1, S2; 42-1, 42-2) for limiting or stopping current flow when a current in the first current direction above a first current limit threshold is measured or when a current in the second current direction above a second current limit threshold is measured.

### Reference sign list:

- 10: aircraft
- 12: propulsion system
- 14: propulsion element
- 16: motor
- 18: load
- 20: DC power source
- 22: energy source
- 24: battery
- 26: fuel cell
- 28: solid state switch
- 30: switching and protection device
- 30': conventional switching and protection device
- 32: DC power network
- 34: controller
- 36-1: first body diode
- 36-2: second body diode
- 38: current detection means
- 40: current detection circuit
- 42-1: first field-effect transistor, FET
- 42-2: second field-effect transistor, FET
- 44: fuse
- 46: diode
- 48: contactor
- 50: bidirectional current path
- B1: replaces the fuse and the diode while keeping their functionality
- B2: replaces the fuse and adds enhanced functionality, e.g., different current protection levels based on the current flow direction
- B3: first and second switches are provided for fuse replacement and to prevent current to energy source, e.g., fuel cell
- B4: replaces three components while keeping their functionality
- B5: replaces two components while keeping their functionality, provides two different protection levels and also diode functionality for fuel cells
- CD: charging current flow direction
- DD: discharging current flow direction
- FD: forward current flow direction
- BD: reverse current flow direction
- S1: first logical switch
- S2: second logical switch

## Claims

1. Solid state switch (28) for a DC power source (20) or a DC power network (32) of an aircraft (10), wherein the solid state switch (28) comprises a first (S1, 42-1) and a second (S2, 42-2) power field-effect transistor electrically connected anti-serial with each other, a current detection means (38) for measuring a current flowing through the anti-serial connected field-effect transistors (S1, S2; 42-1, 42-2), and a controller (34) configured to control the first and second field-effect transistors (S1, S2, 42-1, 42-2) independently from each other, wherein the controller (34) is configured for:
a) conducting a first diode operation with a first current flow direction (FD, DD) by activating the first field-effect transistor (S1, 42-1) and inactivating the second field-effect transistor (S2, 42-2) when the current is below a first threshold and activating the second field-effect transistor (S2, 42-2) when the current is above the first threshold;
b) conducting a second diode operation with a second current flow direction (RD, CD) by activating the second field-effect transistor (S2, 42-2) and inactivating the first field-effect transistor (S1, 42-1) when the current is below a second threshold and activating the first field-effect transistor (S1, 42-1) when the current is above the second threshold; and
c) conducting a fuse operation by inactivating at least one or both of the first and second field-effect transistors (S1, S2; 42-1, 42-2) for limiting or stopping current flow when a current in the first current direction above a third threshold is measured or when a current in the second current direction above a fourth threshold is measured.

2. Solid state switch (28) according to claim 1 wherein
2.1 the first or second threshold is the minimum current that is measurable with the current detection means (38); and/or
2.2 the controller (34) is configured to
a) inactivate, in the first diode operation, the second field-effect transistor (S2, 42-2) again when the current becomes lower than the first threshold, and/or
b) inactivate, in the second diode operation, the first field-effect transistor (S1, 42-1) again when the current becomes lower than the second threshold, and/or
c) conduct the fuse operation with different protection levels and/or different timings depending on the current flow direction; and/or
2.3 conduct a bipolar diode operation wherein the current direction is changed with adapted control commands.

3. Solid state switch (28) according to any of the preceding claims, wherein the controller (34) is configured to control the first and/or second field-effect transistor (S1, S2; 42-1, 42-2) depending on a drain-source voltage level in order to control and/or limit the voltage across the anti-serial connected first and second field-effect transistors.

4. DC power source (20) for an aircraft, comprising an energy source (22) and a solid state switch (28) according to any of the preceding claims arranged to connect the energy source (22) to a load (16, 18, 50).

5. DC power source (20) according to claim 4 wherein the energy source (22) is or comprises a fuel cell (26) and wherein the controller (34) is configured to conduct the first diode operation and the fuse operation wherein the first field-effect transistor (S1, 42-1) is operated as a fuse and the second field-effect transistor (S2, 42-2) is operated as an active diode.

6. DC power source (20) according to claim 4 wherein the energy source (22) is or comprises a rechargeable battery (24) and wherein the controller (34) is configured to conduct the fuse operation wherein the first field-effect transistor (S1, 42-1) is operated as a fuse with the discharge current limit and the second field-effect transistor (S2, 42-2) is operated as a fuse with the charge current limit.

7. DC power network (32) for an aircraft comprising a plurality of DC power sources (20) and several solid state (28) switches according to any of the claims 1 to 3.

8. DC power network (32) according to claim 7, comprising
8.1 at least one DC power source (20) according to any of the claims 4 to 6;
and/or
8.2 at least one bidirectional current path (50) including at least one solid state switch (28) according to any of the claims 1 to 3 connecting the outputs of at least two of the DC power sources.

9. Aircraft (10) comprising a solid-state switch (28) according to any of the claims 1 to 3 or a DC power source (20) according to any of the claims 4 to 6 or a DC power network (32) according to any of the claims 7 or 8.

10. Operation method for operating a solid state switch (28) in a DC power source (20) or in DC power network (32) of an aircraft (10), wherein the solid state switch (28) comprises a first and a second power field-effect transistor (S1, S2; 42-1, 42-2) electrically connected anti-serial with each other, the method comprising:
measuring a current flowing through the anti-serial connected field-effect transistors (S1, S2; 42-1, 42-2), and selectively conducting a first diode operation with a first current flow direction, a second diode operation with a second current flow direction, and a fuse operation by
a) for conducting the first diode operation, activating the first field-effect transistor (S1, 42-1) and inactivating the second field-effect transistor (S2, 42-2) when the current is below a first current threshold and activating the second field-effect transistor (S2, 42-2) when the current is above the first current threshold;
b) for conducting the second diode operation, activating the second field-effect transistor (S2, 42-2) and inactivating the first field-effect transistor (S1, 42-1) when the current is below a second threshold and activating the first field-effect transistor (S1, 42-1) when the current is above the second threshold;
c) for conducting the fuse operation, inactivating at least one or both of the first and second field-effect transistors (S1, S2; 42-1, 42-2) for limiting or stopping current flow when a current in the first current direction above a third threshold is measured or when a current in the second current direction above a fourth threshold is measured.

11. Operation method according to claim 10, comprising at least one of the following steps
11.1 activating, in steps a) or b), both field-effect transistors (S1, S2; 42-1, 42-2) when a current measuring means (38) measures a current above its limit of detection; and/or
11.2
a) inactivating, in the first diode operation, the second field-effect transistor (S2, 42-2) again when the current becomes lower than the first threshold, and/or
b) inactivating, in the second diode operation, the first field-effect transistor (S1, 42-1) again when the current is lower than the second threshold, and/or
c) conducting the fuse operation with different protection levels and/or different timings depending on the current flow direction; and/or
11.3 conducting a bipolar diode operation wherein the current direction is changed with adapted control commands.

12. Operation method according to any of the claims 10 or 11, further comprising:
controlling the first and/or second field-effect transistor (S1, S2; 42-1, 42-2) depending on a drain-source voltage level in order to control and/or limit the voltage across the anti-serial connected first and second field-effect transistors.

13. Method for operating a DC power source (20) for an aircraft (10), the DC power source (20) comprising an energy source (22) and a solid state switch (28) connecting the energy source (22) to a load (16, 18, 50) and including a first and a second power field-effect transistor (S1, S2; 42-1, 42-2) electrically connected anti-serial with each other, wherein the solid states switch (28) is operated with an operation method according to any of the claims 10 to 12 such that
13.1 when the energy source (22) is or comprises a fuel cell (26), the first field-effect transistor (S1, 42-1) is operated as a fuse and the second field-effect transistor (S2, 42-2) is operated as an active diode or
13.2 when the energy source (22) is or comprises a rechargeable battery (26), the first field-effect transistor (S1, 42-1) is operated as a fuse with a discharge current limit and the second field-effect transistor (S2, 42-2) is operated as a fuse with a charge current limit.
